# EUROPÄISCHE PATENTANMELDUNG

(11) **EP 4 521 646 A1**
(43) Veröffentlichungstag der Anmeldung: **12.03.2025**
(21) Anmeldenummer: 23195894.3
(22) Anmeldetag: 07.09.2023
(51) Int. Cl.: H03K 17/97, H01H 23/00, H01H 36/00

(54) **INSTALLATIONSGERÄT MIT EINER FEDER**

(71) Anmelder: Albrecht Jung GmbH & Co. KG, 58579 Schalksmühle (DE)
(72) Erfinder: Biniossek, Nik, 58099 Hagen (DE); Grabovski, Manuel, 58566 Kierspe (DE); Biller, Marius, 58095 Hagen (DE)
(74) Vertreter: Fobbe, Tobias

(57) **Zusammenfassung**

Offenbart ist ein elektrisches/elektronisches Installationsgerät, insbesondere ein Schalter S oder Taster, zum Einbau in eine Installationsdose D, zum Auslösen einer Aktion eines an das Installationsgerät anschließbaren Aktors, insbesondere einer Lampe, einer Jalousie oder dergleichen, wobei das Installationsgerät ein eine Fernbedienbarkeit ermöglichendes Funktionsmodul F mit einem Funksender und mit einem Betätigungssensor aufweist.

Besonderes Kennzeichen dieses elektrischen/elektronischen Installationsgerätes ist, dass das Installationsgerät eine Feder F umfasst, die mechanisch derart durch eine Betätigung des Installationsgerätes, insbesondere durch die Rückseite einer Wippe W oder Wippenaufnahme WA des Installationsgerätes, komprimiert wird, dass diese Betätigung durch einen Betätigungssensor H erfasst und ausgewertet wird, und zudem die derzeitige Schaltstellung der Wippe W ermittelt wird, wobei der Betätigungssensor H als Drucksensor ausgeführt ist und/oder die Feder MF als magnetische Feder, insbesondere eine konische Spiralfeder, und der Betätigungssensor H als Magfnetfeldsensor, insbesondere als Hallsensor, ausgeführt ist.

## Beschreibung

Die Erfindung betrifft ein elektrisches/elektronisches Installationsgerät, insbesondere einen Schalter oder Taster, zum Einbau in eine Installationsdose, zum Auslösen einer Aktion eines an das Installationsgerät anschließbaren Aktors, insbesondere einer Lampe, einer Jalousie oder dergleichen, wobei das Installationsgerät ein eine Fernbedienbarkeit ermöglichendes Funktionsmodul mit einem Funksender und mit einem Betätigungssensor aufweist.

Elektrische/elektronische Installationsgeräte (beispielsweise Taster oder Schalter) werden zunehmend im Zusammenhang mit Funktionsmodulen eingesetzt, um eine Fernbedienbarkeit von an die Installationsgeräte angeschlossenen Aktoren, insbesondere einer Lampe, einer Jalousie oder dergleichen, zu ermöglichen.

Derartige Installationsgeräte sind aus dem Stand der Technik beispielsweise gemäß der Website *nexentro.de* bekannt. Ein solches Funktionsmodul ist für die Gebäudeinstallationstechnik ausgelegt und weist ein aus einem Sockelteil und einem Deckelteil bestehendes Gehäuse auf, in dessen Innenraum auf zumindest einer elektrischen Leiterplatte die zur Funktion notwendigen elektrischen/elektronischen Bauteile untergebracht sind. Die elektrische Leiterplatte steht mit mehreren Anschlusskabeln zur Bildung einer Schnittstelle in Verbindung, über welche der Anschluss eines elektrischen/elektronischen Schaltgerätes, eines Schalters oder eines Tasters, erfolgt. Über mehrere unabhängige Kanäle können Telegramme ausgesendet werden, wobei die Telegramme zur Ansteuerung verschiedener Aktoren, beispielsweise Leuchten, Jalousien oder Steckdosen, oder Sensoren, beispielsweise Tastsensoren, Verwendung finden. Durch die Installation der Funktionsmodule in Installationsdosen werden die herkömmlichen, elektromechanischen Schalter "smart" gemacht.

Um das Tastsignal eines elektromechanischen Schalters an einem vorbekannten Funktionsmodul auswerten zu können, müssen mindestens drei Leitungen angeschlossen werden (Außenleiter beziehungsweise Phase L und geschalteter Ausgang/Steuerleitung und eine Steuerleitung zum Anschluss des Schalters). Bei Zweifach- und Jalousieanwendungen kommt eine weitere Steuerleitung hinzu; bei Schalt- oder Dimm-Anwendungen eine oder zwei Steuerleitungen.

Da durch den begrenzten Platzbedarf eine Unterbringung eines Funktionsmoduls und des Kabelgutes in der Unterputzdose herausfordernd ist, stellt das Weglassen jeder Leitung eine erhebliche Optimierung dar, insbesondere, weil der Platzbedarf in dem Installationshohlraum und der Installationsaufwand signifikant abgesenkt werden können. Zudem wird durch die reduzierte Anzahl von zu verwendenden elektrischen Leitungen der Aufbau verständlicher und kann so durch die installierende Person sicherer und nachvollziehbarer durchgeführt werden. Mithin ergeben sich weniger Fehlerquellen. Aus diesen Gründen ergeben sich Hinderungsgründe für die breite Masse der Anwender, die kein Fachinstallateur sind, ein vorstehend beschriebenes Funktionsmodul im Zusammenhang mit einem elektrischen/elektronischen Installationsgerät einzusetzen.

Aus WO / 2023 104 379 A1 ist daher ein elektrisches/elektronisches Installationsgerät, insbesondere ein Schalter oder ein Taster, zum Einbau in eine Installationsdose, zum Auslösen einer Aktion eines an das Installationsgerät anschließbaren Aktors, insbesondere einer Lampe, einer Jalousie oder dergleichen, bekannt geworden, wobei das Installationsgerät ein eine Fernbedienbarkeit ermöglichendes Funktionsmodul mit einem Funksender und mit einem Betätigungssensor aufweist, wobei der Betätigungssensor als Magnetfeldsensor ausgeführt ist. Dieser Magnetfeldsensor ermittelt die mit der Betätigung einhergehende Positionsänderung eines an die Wippe angeschlossenen, insbesondere geklebten, Magneten. Vorteilhaft dabei ist, dass der Verkabelungsaufwand und der Platzbedarf in einer Installationsdose hierdurch massiv abgesenkt werden können, da es keine (herzustellende) elektrische Verkabelung zwischen dem Installationsgerät, insbesondere einen Schalter oder einen Taster, und dem Funktionsmodul erfordert.

Problematisch bei derartigen Installationsgeräten ist jedoch, dass aufgrund der Distanz zwischen dem an der Wippe angeordneten Magneten und dem im Funktionsmodul angeordneten Magnetfeldsensor ein verhältnismäßig platzraubender Magnet zur Erreichung eines ausreichenden Signal-zu-Rausch-Verhältnisses und/oder ein kostspieliger, sensitiver Sensor eingesetzt werden muss.

Darüber hinaus stellt das Anbringen des Magneten an der Wippe nicht nur einen zusätzlichen Montageprozess dar, sondern führt die Unterschiedlichkeit der Positionierung und Geometrie unterschiedlicher Wippen mitunter zu einer nicht wohldefinierten, unkontrollierbaren Ausgangssituation, die ein individuelles Einlernen des Magnetfeldsensors bezüglich des Magnetsignals erforderlich macht, so dass die Inbetriebnahme eines solchen Installationsgerätes mit einem Funktionsmodul relativ aufwendig ist. Als unerwünschte Nebenwirkung tritt dabei der Effekt auf, dass der Einsatz schwerer Magneten die Haptik bei der Betätigung beeinträchtigt.

Ausgehend von diesem diskutierten Stand der Technik liegt der Erfindung die Aufgabe zugrunde, ein elektrisches/elektronisches Installationsgerät zu schaffen, das sich durch ein gutes Signal-zu-Rausch-Verhältnis, eine vereinfachte Montage, einen geringen Platzbedarf, geringe Herstellungskosten und eine gute Bedienhaptik auszeichnet.

Gelöst wird diese Aufgabe durch ein elektrisches/elektronisches Installationsgerät, das eine Feder umfasst, die mechanisch derart durch eine Betätigung des Installationsgerätes, insbesondere durch die Rückseite einer Wippe oder Wippenaufnahme des Installationsgerätes, komprimiert wird, dass diese Betätigung durch einen Betätigungssensor erfasst und ausgewertet wird, und zudem die derzeitige Schaltstellung der Wippe ermittelt wird, wobei der Betätigungssensor als Drucksensor ausgeführt ist und/oder die Feder als magnetische Feder, insbesondere eine konische Spiralfeder, und der Betätigungssensor (H) als Magnetfeldsensor, insbesondere als Hallsensor, ausgeführt ist.

Der Kerngedanke der Erfindung besteht zum einen darin, dass durch den Einsatz einer erfindungsgemäßen Feder, die mechanisch durch eine Betätigung des Installationsgerätes komprimiert wird, wobei die Betätigung durch einen Betätigungssensor erfasst und ausgewertet wird, der Vorteil gegenüber vorbekannten Installationsgeräten erreicht wird, dass ein Einkleben eines Magnets an die Rückseite der Wippe entfällt. Vielmehr ist bei dem erfindungsgemäßen Installationsgerät die (magnetische) Feder bereits fest verbauter Bestandteil des Installationsgerätes, so dass durch den Betätigungssensor entweder der Druck und/oder das Magnetfeld erfasst wird, ohne dass ein separater Magnet an der Rückseite der Wippe befestigt wird. Neben der Vereinfachung der Montage werden somit durch den Entfall des Einklebens eines Magneten auch zwangsläufig gewisse Ungenauigkeiten in der Positionierung des Magneten an der Wippe vermieden, so dass Abweichungen in dem Signal-zu-Rausch-Verhältnis minimiert werden. Dieses hat zur Folge, dass sogar auf eine individuelle Kalibrierung des Magnetfeldsensors mit Blick auf den Magneten an der Wippe beziehungsweise die magnetische Feder verzichtet werden kann. Die Tatsache, dass die magnetische Feder durch die Betätigung komprimiert wird, geht zudem mit dem Vorteil einher, dass die Feder zwingend in dem Bereich zwischen Wippe oder Wippenaufnahme und Boden der Installationsdose angeordnet ist, so dass die Distanz zum Magnetfeldsensor im Vergleich zum an die Wippe geklebten Magneten geringer beziehungsweise das Signal-zu-Rausch-Verhältnis weiter verbessert ist. Durch die vorstehenden Aspekte, die zur Verbesserung des Signal-zu-Rausch-Verhältnisses beitragen, wird der weitere Vorteil erreicht, dass ein kostengünstigerer Magnetfeldsensor eingesetzt werden kann.

Zum anderen erlaubt die (magnetische) Feder nicht nur eine magnetische Detektion der Betätigung des erfindungsgemäßen elektrischen/elektronischen Installationsgerätes, sondern übernimmt gleichzeitig auch die Aufgabe, die Haptik bei der Betätigung einzustellen, beispielsweise über die Wahl der mechanischen Parameter der Feder. Insofern besteht im Vergleich zum Stand der Technik ein verringerter Teile-, Montage- und Platzbedarf.

Bezüglich der Fernbedienbarkeit der an das elektrische/elektronische Installationsgerät anschließbaren Aktoren wird die Erfassung und Auswertung der Betätigung durch einen Betätigungssensor erfindungsgemäß dafür genutzt, auf die derzeitige Schaltstellung der Wippe des elektrischen/elektronischen Installationsgerätes zurückzuschließen. Dabei korrespondieren die Endstellungen während (Taster) oder nach (Schalter) einer Betätigung zu einem konkreten Wert des Magnetfeldes oder des Drucks, jedenfalls zu einer konkreten Änderung des Magnetfeldes oder des Drucks, so dass die Schaltstellung in die Ansteuerung der Aktoren mit einfließen kann. So wird es beispielsweise möglich, dass in einer entsprechenden Anwendung auf einem mobilen Endgerät die jeweilige Schaltstellung korrekt angezeigt wird. Hierdurch wird es beispielsweise möglich, dass der Anwender sein Licht (zutreffend) bei Abwesenheit ein- beziehungsweise ausschalten kann, beispielsweise um eine Anwesenheit während eines Urlaubs zu simulieren.

In der besonders zuverlässigen Ausgestaltung der Erfindung, ist der Betätigungssensor sowohl dazu eingerichtet, den Druck bei der Betätigung der magnetischen Feder als auch das Magnetfeld zu erfassen. Erst wenn beide Sensorergebnisse übereinstimmend eine Betätigung indizieren, wird eine solche auch erkannt.

Gemäß einer bevorzugten Ausgestaltung des erfindungsgemäßen elektrischen/elektronischen Installationsgerätes ist die magnetische Feder bevorzugt als Spiralfeder ausgeführt. Hierdurch wird der bezüglich einer normalen (nicht als Spiralfeder ausgeführten) Feder erforderliche Bauraum minimiert. In einer besonders bevorzugten Weiterbildung dieser Ausgestaltung des erfindungsgemäßen elektrischen/elektronischen Installationsgerätes ist die magnetische Feder besonders platzsparend als konische Spiralfeder ausgeführt. Dann können sich die Windungen der Spiralfeder im komprimierten Zustand nebeneinanderlegen.

Gemäß einer bevorzugten Ausgestaltung des erfindungsgemäßen elektrischen/elektronischen Installationsgerätes handelt es sich bei dem elektrischen/elektronischen Installationsgerät um einen Taster mit einer Feder, die zur Wipprückstellung ohnehin verbaut ist, so dass die Feder ohnehin bereits vorhanden ist. In einem solchen Fall, kann zur Sensierung des Drucks und des Magnetfeldes, beziehungsweise deren Änderung in Folge der Betätigung, ein Magnet an die Feder ankoppelbar sein, der sich bei der Kompression der Feder bewegt und so eine Magnetfeldänderung herbeiführt.

Gemäß einer weiteren besonders bevorzugten Ausgestaltung des erfindungsgemäßen elektrischen/elektronischen Installationsgerätes ist die (magnetische) Feder an das Funktionsmodul, das an das elektrische/elektronische Installationsgerät ankoppelbar ist, angeformt. Hierdurch wird es einerseits auf besonders vorteilhafte Art und Weise - gerade mit Blick auf das Signal-zu-Rausch-Verhältnis - ermöglicht, dass der Abstand zwischen (magnetischer) Feder und Betätigungssensor, der im Funktionsmodul angeordnet ist, minimal ist, während es andererseits ermöglicht wird, das Funktionsmodul mit der Feder vorzuproduzieren und an bestehende Schalter oder Taster im Wege der Nachrüstung anzukoppeln. Bis dato ging eine Nachrüstung mit einem Funktionsmodul mit Magnetsensor mit der Notwendigkeit einher, dass ein Magnet in die Wippe einzukleben war, wobei dieser zusätzliche Schritt durch die an das Funktionsmodul angekoppelte Feder gerade vermieden ist. Auch ist durch die positionsfestgelegte Positionierung der Feder an dem Funktionsmodul, welches regelmäßig ebenfalls mit dem Schalter oder Taster formschlüssig gekoppelt wird, eine definierte Position der magnetischen Feder zu dem Magnetfeldsensor gegeben.

In einer bevorzugten Ausführung der Erfindung, die mit einem außerordentlich guten Signal-zu-Rausch-Verhältnis einhergeht, ist die magnetische Feder mit ihrem ersten Ende an das Funktionsmodul an einem Anschlusspunkt angeschlossen und weist mit ihrem zweiten Ende in Richtung der Wippe oder Wippenaufnahme, wobei der Magnetfeldsensor im Bereich von weniger als 20 mm entfernt von dem Anschlusspunkt angeordnet ist. Dieses wird beispielsweise dadurch erreicht, indem Anschlusspunkt und Magnetfeldsensor in einer Seitenansicht benachbart zueinander angeordnet sind.

In einer weiteren, kostengünstigen Ausführungsform der Erfindung ist der Magnetfeldsensor ein MEMS-Magnetsensor, auch bekannt als Mikrosystemtechnik(MST)-Sensor. Aufgrund der geringen Größe des MEMS-Magnetsensors kann dieser besonders nahe am Messort platziert werden, wodurch eine höhere räumliche Auflösung im Vergleich zu anderen Magnetfeldsensoren erreicht wird. Zudem ist der MEMS-Magnetsensor besonders kostengünstig und erlaubt eine besonders präzise mehrdimensionale vektorielle Auswertung.

In einer bevorzugten Ausführung der Erfindung, die mit einem weiter verbesserten guten Signal-zu-Rausch-Verhältnis einhergeht, weist die magnetische Feder einen an sie angekoppelten Magneten auf. Hierdurch wird das Magnetfeld weiter verstärkt und somit das Signal-zu-Rausch-Verhältnis. Dieses erlaubt zudem, auch weniger stark magnetische Materialien für die magnetische Feder zu verwenden, so dass eine größere Vielfalt an Materialien in Frage kommt, so dass die Haptik bei der Kompression der Feder beziehungsweise der Vor-Ort-Betätigung besser über die Materialwahl der Feder einstellbar ist.

Gemäß einer weiteren Ausführungsform der Erfindung umfasst das Funktionsmodul einen Dimmaktor zum Dimmen einer Lampe.

Gemäß einer weiteren Ausführungsform der Erfindung umfasst das Funktionsmodul einen Schaltaktor zum Schalten eines elektrischen Gerätes.

Nachfolgend ist die Erfindung unter Bezugnahme auf die beigefügten Figuren anhand eines Ausführungsbeispiels beschrieben. Es zeigt:
- **Fig. 1:**: eine schematische Darstellung des erfindungsgemäßen elektrischen/ elektronischen Installationsgerätes umfassend eine Wippe, einen Schalter und ein Funktionsmodul, und
- **Fig. 2:**: eine schematische Darstellung des erfindungsgemäßen elektrischen/ elektronischen Installationsgerätes in einer Seitenansicht, wobei das elektrische/elektronische Installationsgerät in einer Installationsdose verbaut ist.

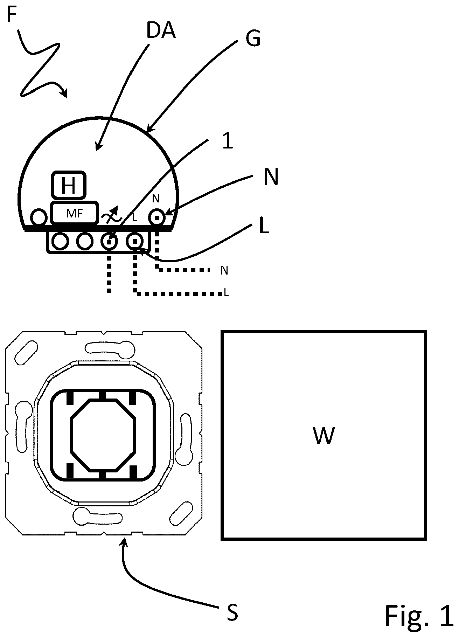

Figur 1 zeigt eine schematische Darstellung des erfindungsgemäßen elektrischen/ elektronischen Installationsgerätes umfassend eine Wippe W, einen Schalter S und ein Funktionsmodul F, in dessen Gehäuse G vorliegend ein Dimmaktor DA angeordnet ist. Zum Verbau in einer Installationsdose D weist ein solches Funktionsmodul F eine Steuerleitung 1 auf, sowie einen Anschluss an die Phase L und an den Neutralleiter N. Ein elektrischer Anschluss des Funktionsmoduls F an den Schalter S ist, im Gegensatz zu den klassischen Funktionsmodulen F, gerade nicht erforderlich, so dass weniger Kabelgut in der Installationsdose D unterzubringen ist. Der im Funktionsmodul F untergebrachte Magnetfeldsensor H detektiert die mechanische Kompression der magnetischen Feder MF als Indikator einer Betätigung des Schalters S. Vorteilhaft dabei ist, dass durch die magnetische Feder MF, insbesondere durch die Einstellung der Federkonstante, die Rückstellkraft und damit die Haptik beim Betätigen der Wippe W ermöglicht wird. Dieser Freiheitsgrad ist gerade deswegen interessant, da durch die Betätigung der Wippe W kein elektrischer Kontakt (wie bei klassischen Schaltern oder Tastern) herzustellen ist, so dass der Kraftaufwand deutlich geringer ausfallen kann. Insofern wird durch die erfindungsgemäße Lösung die Haptik beim Betätigen besonders gut, insbesondere auf besonders sanft, einstellbar, wobei gleichzeitig durch den Fakt, dass die Feder MF magnetisch ausgeführt ist, auf den im Stand der Technik zum Einsatz kommenden Magneten verzichtet werden kann.

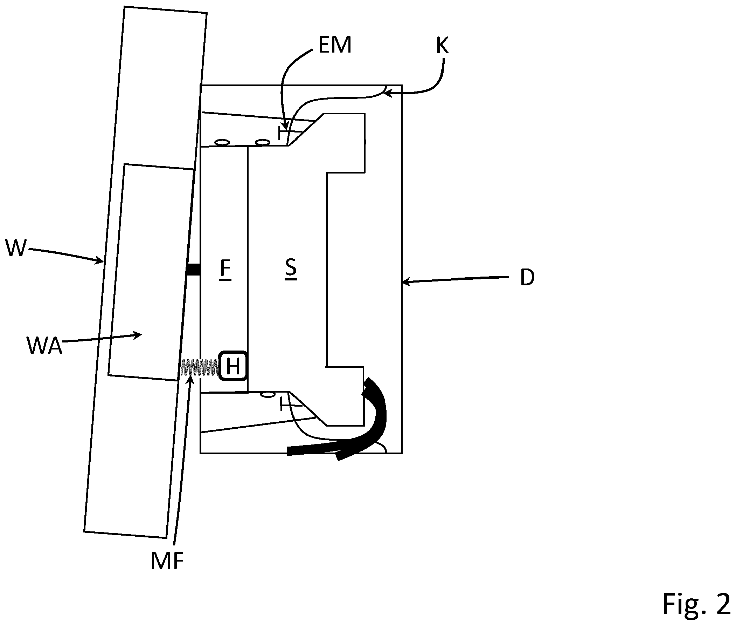

Figur 2 zeigt eine schematische Darstellung des erfindungsgemäßen elektrischen/ elektronischen Installationsgerätes in einer Seitenansicht, wobei das elektrische/ elektronische Installationsgerät in einer Installationsdose D verbaut ist. Die Festlegung in der Installationsdose D erfolgt mittels Spreizkrallen K, die über Einstellmittel EM bedienbar sind. Erkennbar ist, dass die Wippenaufnahme WA eine Wippe W aufweist, wobei in der dargestellten Ausführungsform die magnetische Feder MF so angeordnet ist, dass sie bei einer Vor-Ort-Betätigung des Schalters S komprimiert wird, so dass die damit einhergehende Änderung des Magnetfeldes im Magnetfeldsensor H erfasst und ausgewertet wird, so dass auf die Schaltstellung der Wippe W zurückgeschlossen wird. Dieses erlaubt eine Fernbedienbarkeit über das einen Funksender aufweisende Funktionsmodul F, wobei der aktuelle Schaltzustand auf einem Endgerät visualisierbar und zu berücksichtigen ist. In einer anderen Ausgestaltung der Erfindung kann das Funktionsmodul F auch rückseitig an den Schalter S oder einen Taster angekoppelt werden, wobei die magnetische Feder MF in einem solchen Fall durch den Schalter S oder Taster hindurchgreift.

Die Erfindung ist anhand mehrerer Ausführungsbeispiele beschrieben. Ohne den Umfang der geltenden Ansprüche zu verlassen, ergeben sich für einen Fachmann zahlreiche weitere Möglichkeiten, diese umzusetzen, ohne dass dieses im Rahmen dieser Ausführungen im Einzelnen erläutert werden müsste.

### Bezugszeichenliste

- 1: Steuerleitung

- DA: Dimmaktor
- D: Installationsdose
- EM: Einstellmittel
- F: Funktionsmodul
- G: Gehäuse
- H: Magnetfeldsensor
- K: Spreizkralle
- L: Phase
- MF: magnetische Feder
- N: Neutralleiter
- S: Schalter
- WA: Wippenaufnahme
- W: Wippe

## Patentansprüche

1. Elektrisches/elektronisches Installationsgerät, insbesondere ein Schalter (S) oder Taster, zum Einbau in eine Installationsdose (D), zum Auslösen einer Aktion eines an das Installationsgerät anschließbaren Aktors, insbesondere einer Lampe, einer Jalousie oder dergleichen, wobei das Installationsgerät ein eine Fernbedienbarkeit ermöglichendes Funktionsmodul (F) mit einem Funksender und mit einem Betätigungssensor aufweist, **dadurch gekennzeichnet, dass** das Installationsgerät eine Feder (MF) umfasst, die mechanisch derart durch eine Betätigung des Installationsgerätes, insbesondere durch die Rückseite einer Wippe (W) oder Wippenaufnahme (WA) des Installationsgerätes, komprimiert wird, dass diese Betätigung durch einen Betätigungssensor (H) erfasst und ausgewertet wird, und zudem die derzeitige Schaltstellung der Wippe (W) ermittelt wird, wobei der Betätigungssensor (H) als Drucksensor ausgeführt ist und/oder die Feder (MF) als magnetische Feder, insbesondere eine konische Spiralfeder, und der Betätigungssensor (H) als Magnetfeldsensor, insbesondere als Hallsensor, ausgeführt ist.

2. Elektrisches/elektronisches Installationsgerät nach Anspruch 2, **dadurch gekennzeichnet, dass** es sich bei dem elektrischen/elektronischen Installationsgerät um einen Taster mit einer Feder, die zur Wipprückstellung ohnehin verbaut ist, handelt.

3. Elektrisches/elektronisches Installationsgerät nach einem der Ansprüche 1 bis 2, **dadurch gekennzeichnet, dass** die Feder (MF) an das Funktionsmodul (F), das an das elektrische/elektronische Installationsgerät ankoppelbar ist, angeformt ist.

4. Elektrisches/elektronisches Installationsgerät nach einem der Ansprüche 3 bis 3, **dadurch gekennzeichnet, dass** die magnetische Feder (MF) mit ihrem ersten Ende an das Funktionsmodul (F) an einem Anschlusspunkt angeschlossen ist und mit ihrem zweiten Ende in Richtung der Wippe (W) oder Wippenaufnahme (WA) weist, wobei der Magnetfeldsensor (H) im Bereich von weniger als 20 mm entfernt von dem Anschlusspunkt angeordnet ist.

5. Elektrisches/elektronisches Installationsgerät nach einem der Ansprüche 3 bis 4, **dadurch gekennzeichnet, dass** der Magnetfeldsensor (H) ein MEMS-Magnetsensor ist

6. Elektrisches/elektronisches Installationsgerät nach einem der Ansprüche 3 bis 5, **dadurch gekennzeichnet, dass** an die (magnetische) Feder (MF) ein weiterer Magnet angekoppelt ist, der das Magnetfeld weiter verstärkt.

7. Elektrisches/elektronisches Installationsgerät nach einem der Ansprüche 1 bis 6, **dadurch gekennzeichnet, dass** das elektrische/elektronische Installationsgerät ein Schalter (S) oder ein Taster ist.

8. Elektrisches/elektronisches Installationsgerät nach einem der Ansprüche 1 bis 7, **dadurch gekennzeichnet, dass** das Funktionsmodul (F) einen Dimmaktor (DA) zum Dimmen einer Lampe umfasst.

9. Elektrisches/elektronisches Installationsgerät nach einem der Ansprüche 1 bis 8, **dadurch gekennzeichnet, dass** das Funktionsmodul (F) einen Schaltaktor zum Schalten eines elektrischen Gerätes umfasst.

10. Elektrisches/ elektronisches Installationsgerät nach einem der Ansprüche 1 bis 9, **dadurch gekennzeichnet, dass** das Funktionsmodul (F) an ein Relais angeschlossen ist.

11. Elektrisches/ elektronisches Installationsgerät nach einem der Ansprüche 1 bis 10, **dadurch gekennzeichnet, dass** das Funktionsmodul (F) als Bestandteil eines modularen Baukastensystems an das elektrische/elektronische Installationsgerät ankoppelbar ist.

## Geänderte Patentansprüche

### Geänderte Patentansprüche gemäss Regel 137(2) EPÜ.

1. Elektrisches/elektronisches Installationsgerät zum Einbau in eine Installationsdose (D), zum Auslösen einer Aktion eines an das Installationsgerät anschließbaren Aktorswobei das Installationsgerät ein eine Fernbedienbarkeit ermöglichendes Funktionsmodul (F) mit einem Betätigungssensor (H) aufweist, wobei das Installationsgerät eine Feder (MF) umfasst, die mechanisch derart durch eine Betätigung des Installationsgerätes komprimiert wird, dass diese Betätigung durch einen Betätigungssensor (H) erfasst und ausgewertet wird, und zudem die derzeitige Schaltstellung einer Wippe (W) ermittelt wird, wobei der Betätigungssensor (H) als Drucksensor ausgeführt ist oder die Feder (MF) als magnetische Federund der Betätigungssensor (H) als Magnetfeldsensorausgeführt ist **dadurch gekennzeichnet, dass** das Funktionsmodul einen Funksender aufweist und dass die Feder (MF) an das Funktionsmodul (F), das an das elektrische/elektronische Installationsgerät ankoppelbar ist, angeformt ist und die magnetische Feder (MF) mit ihrem ersten Ende an das Funktionsmodul (F) an einem Anschlusspunkt angeschlossen ist und mit ihrem zweiten Ende in Richtung einer Wippe (W) oder Wippenaufnahme (WA) weist, wobei der Magnetfeldsensor (H) im Bereich von weniger als 20 mm entfernt von dem Anschlusspunkt angeordnet ist.

2. Elektrisches/elektronisches Installationsgerät nach Anspruch 1, **dadurch gekennzeichnet, dass** es sich bei dem elektrischen/elektronischen Installationsgerät um einen Taster mit einer Feder, die zur Wipprückstellung ohnehin verbaut ist, handelt.

3. Elektrisches/elektronisches Installationsgerät nach einem der Ansprüche 1 bis 2, **dadurch gekennzeichnet, dass** der Magnetfeldsensor (H) ein MEMS-Magnetsensor ist

4. Elektrisches/elektronisches Installationsgerät nach einem der Ansprüche 1 bis 3, **dadurch gekennzeichnet, dass** an die (magnetische) Feder (MF) ein weiterer Magnet angekoppelt ist, der das Magnetfeld weiter verstärkt.

5. Elektrisches/elektronisches Installationsgerät nach einem der Ansprüche 1 bis 4, **dadurch gekennzeichnet, dass** das elektrische/elektronische Installationsgerät ein Schalter (S) oder ein Taster ist.

6. Elektrisches/elektronisches Installationsgerät nach einem der Ansprüche 1 bis 5, **dadurch gekennzeichnet, dass** das Funktionsmodul (F) einen Dimmaktor (DA) zum Dimmen einer Lampe umfasst.

7. Elektrisches/elektronisches Installationsgerät nach einem der Ansprüche 1 bis 6, **dadurch gekennzeichnet, dass** das Funktionsmodul (F) einen Schaltaktor zum Schalten eines elektrischen Gerätes umfasst.

8. Elektrisches/ elektronisches Installationsgerät nach einem der Ansprüche 1 bis 7, **dadurch gekennzeichnet, dass** das Funktionsmodul (F) an ein Relais angeschlossen ist.

9. Elektrisches/ elektronisches Installationsgerät nach einem der Ansprüche 1 bis 8, **dadurch gekennzeichnet, dass** das Funktionsmodul (F) als Bestandteil eines modularen Baukastensystems an das elektrische/elektronische Installationsgerät ankoppelbar ist.
